# EUROPEAN PATENT APPLICATION

(11) **EP 4 712 128 A1**
(43) Date of publication of application: **18.03.2026**
(21) Application number: 24210486.7
(22) Date of filing: 04.11.2024
(51) Int. Cl.: H01L 21/48, H01L 23/498, H01L 23/538, H01L 25/065

(54) **INTERCONNECTION MODULE SUBSTRATE FOR SEMICONDUCTOR PACKAGE, SEMICONDUCTOR PACKAGE DEVICE INCLUDING THE SAME, AND MANUFACTURING METHODS THEREOF**

(30) Priority: 13.09.2024 KR 20240125780
(71) Applicant: Silicon Box Pte. Ltd., Singapore 529580 (SG)
(72) Inventor: HAN, Byung Joon, 06067 SEOUL (KR); HAN, Young Michael, NEW YORK, 10010 (US); AHN, Byung Hoon, 16941 GYEONGGI-DO (KR)
(74) Representative: Cabinet Beaumont

(57) **Abstract**

Disclosed are an interconnection module substrate for a semiconductor package, a semiconductor package device including the same, and manufacturing methods thereof. The interconnection module substrate includes a plurality of via-defining structures disposed spaced apart from each other in a horizontal direction, each of the plurality of via-defining structures including a substrate material unit and a conductive via element extending through the substrate material unit in a vertical direction, at least one interconnection bridge member disposed spaced apart from or adjacent to the plurality of via-defining structures in the horizontal direction, and a substrate material layer embedded in the space between and around the plurality of via-defining structures and the interconnection bridge member to form a single substrate shape together therewith, the substrate material layer being configured to expose the plurality of via-defining structures and the interconnection bridge member.

## Description

### BACKGROUND OF THE INVENTION

### 1. Field of the invention

The present invention relates to technologies and methods related to a semiconductor package, and more particularly to a substrate for a semiconductor package, a semiconductor package device including the same, and manufacturing methods thereof.

### 2. Description of the Related Art

A semiconductor process may be divided into a front-end process of manufacturing a wafer and engraving a circuit and a back-end process of packaging a chip. As semiconductor miniaturization technology approaches its limits, importance of the back-end process is further increasing. In this regard, advanced packaging technology of integrating different semiconductor chips or vertically connecting a plurality of chips is emerging as an important technology.

2.5-dimensional (2.5D) packaging is packaging technology for integrating a plurality of semiconductor chips (dies) into a single package in the state of being horizontally disposed. 2.5D packaging is different from 3D packaging in that each chip is disposed on an interposer, which is a packaging component. A logic chip, a memory chip, etc. may be horizontally disposed on the interposer. Connectivity between chips may be improved by connecting the chips to each other through interconnect technology.

Embedded multi-die interconnect bridge (EMIB) technology uses a silicon interposer to connect heterogeneous semiconductor chips (dies) to each other, wherein the silicon interposer is embedded in a flip chip ball grid array (FC-BGA) substrate, which is called a "silicon bridge." EMIB technology has advantages such as reduced board area and package height and lower power consumption, and may lower production costs because the area of the silicon bridge is less than that of a typical silicon interposer. However, for a package substrate in which a silicon bridge used in the EMIB is embedded, it may be difficult to mount chips having two or more different electrode pitches on a single substrate due to lack of adequate responsiveness to different electrode pitches and pattern resolution differences. In addition, the package substrate of the EMIB may be difficult to adapt for implementation of various semiconductor package designs, may not be easy to manufacture, and may suffer from reduced durability due to deformation, etc.

Therefore, there is a need to develop an interconnection substrate for a semiconductor package that is easy to variously design and easy to manufacture according to user need and purpose. In addition, there is a need to develop an interconnection substrate for a semiconductor package which can be appropriately manufactured in response to various semiconductor package design plans, which can secure responsiveness to various electrode pitches, and which has excellent performance and durability.

### SUMMARY OF THE INVENTION

It is an object of the present invention to provide an interconnection module substrate for a semiconductor package that is easy to variously design and easy to manufacture according to user need and purpose.

It is another object of the present invention to provide an interconnection module substrate for a semiconductor package which can be appropriately manufactured in response to various semiconductor package design plans, which can secure responsiveness to various electrode pitches, and which has excellent performance and durability.

It is another object of the present invention to provide a semiconductor package device to which the interconnection module substrate is applied.

It is a further object of the present invention to provide methods of manufacturing the interconnection module substrate and the semiconductor package device.

Objects of the present invention are not limited to the aforementioned objects, and other unmentioned objects will be understood by those skilled in the art based on the following description.

In accordance with one aspect of the present invention, the above and other objects can be accomplished by the provision of an interconnection module substrate for a semiconductor package, the interconnection module substrate including a plurality of via-defining structures disposed spaced apart from each other in a horizontal direction, each of the plurality of via-defining structures including a substrate material unit and a conductive via element extending through the substrate material unit in a vertical direction, at least one interconnection bridge member disposed spaced apart from or adjacent to the plurality of via-defining structures in the horizontal direction, and a substrate material layer embedded in the space between and around the plurality of via-defining structures and the interconnection bridge member to form a single substrate shape together therewith, the substrate material layer being configured to expose the plurality of via-defining structures and the interconnection bridge member.

The plurality of via-defining structures may include a first via-defining structure, the first via-defining structure may include first and second conductive via elements spaced apart from each other, and the first and second conductive via elements may have the same spacing at upper ends and lower ends thereof.

The plurality of via-defining structures may include a first via-defining structure, the first via-defining structure may include first and second conductive via elements spaced apart from each other, and the first and second conductive via elements may have a first spacing at upper ends thereof and may have a second spacing greater than the first spacing at lower ends thereof.

At least one of the first and second conductive via elements may have a bent structure.

The interconnection bridge member may include a first connection pad portion electrically connected to a first semiconductor chip and a second connection pad portion electrically connected to a second semiconductor chip.

The interconnection bridge member may include a base portion and a wiring structure formed on the base portion.

The interconnection bridge member may have a thickness less than the thickness of the substrate material layer.

The interconnection bridge member may have the same thickness or substantially the same thickness as the substrate material layer, and the interconnection bridge member may include a through silicon via (TSV) or a through electrode equivalent thereto.

In accordance with another aspect of the present invention, there is provided a semiconductor package device including the interconnection module substrate and a plurality of semiconductor chips mounted on an upper surface of the interconnection module substrate so as to be spaced apart from or adjacent to each other in the horizontal direction.

The plurality of semiconductor chips may include first and second semiconductor chips, the plurality of via-defining structures may include first and second via-defining structures, the at least one interconnection bridge member may include a first interconnection bridge member disposed between the first and second via-defining structures, the first semiconductor chip may be connected to a conductive via element of the first via-defining structure and a first connection pad portion of the first interconnection bridge member, and the second semiconductor chip may be connected to a conductive via element of the second via-defining structure and a second connection pad portion of the first interconnection bridge member.

A first electrical connection element may be disposed between the interconnection module substrate and the semiconductor chip, and a second electrical connection element connected to the conductive via element may be disposed on a lower surface of the interconnection module substrate.

In accordance with another aspect of the present invention, there is provided a method of manufacturing an interconnection module substrate for a semiconductor package, the method including disposing a plurality of preformed via-defining structures, each including a substrate material unit and a conductive via element extending through the substrate material unit in the vertical direction, and at least one interconnection bridge member on a temporary substrate so as to be spaced apart from or adjacent to each other in the horizontal direction, forming a substrate material layer embedded in the space between and around the plurality of via-defining structures and the interconnection bridge member to form a single substrate shape together therewith on the temporary substrate, and removing the temporary substrate from an interconnection module substrate including the plurality of preformed via-defining structures, the interconnection bridge member, and the substrate material layer.

The method may further include grinding at least one of an upper surface and a lower surface of the interconnection module substrate.

The plurality of preformed via-defining structures may include a first via-defining structure, the first via-defining structure may include first and second conductive via elements spaced apart from each other, and the first and second conductive via elements may have the same spacing at upper ends and lower ends thereof.

The plurality of preformed via-defining structures may include a first via-defining structure, the first via-defining structure may include first and second conductive via elements spaced apart from each other, and the first and second conductive via elements may have a first spacing at upper ends thereof and may have a second spacing greater than the first spacing at lower ends thereof.

At least one of the first and second conductive via elements may have a bent structure.

The interconnection bridge member may have a thickness less than the thickness of the substrate material layer.

The interconnection bridge member may have the same thickness or substantially the same thickness as the substrate material layer, and the interconnection bridge member may include a through silicon via (TSV) or a through electrode equivalent thereto.

In accordance with a further aspect of the present invention, there is provided a method of manufacturing a semiconductor package device, the method including preparing an interconnection module substrate using the above method and mounting a plurality of semiconductor chips on an upper surface of the interconnection module substrate so as to be spaced apart from or adjacent to each other in the horizontal direction.

The method may further include forming an electrical connection element connected to the conductive via element on a lower surface of the interconnection module substrate.

### BRIEF DESCRIPTION OF THE DRAWINGS

FIG. 1 is a sectional view schematically showing an interconnection module substrate for a semiconductor package according to an embodiment of the present invention;
FIG. 2 is a sectional view schematically showing an interconnection module substrate for a semiconductor package according to another embodiment of the present invention;
FIG. 3 is a sectional view schematically showing an interconnection module substrate for a semiconductor package according to another embodiment of the present invention;
FIG. 4 is a sectional view schematically showing an interconnection module substrate for a semiconductor package according to a further embodiment of the present invention;
FIG. 5 is a sectional view schematically showing a semiconductor package device including an interconnection module substrate for a semiconductor package according to an embodiment of the present invention;
FIG. 6 is a sectional view schematically showing a semiconductor package device including an interconnection module substrate for a semiconductor package according to another embodiment of the present invention;
FIGs. 7 to 10 are sectional views exemplarily showing via-defining structures that can be applied to an interconnection module substrate for a semiconductor package according to an embodiment of the present invention;
FIG. 11 is a plan view exemplarily showing a via-defining structure that can be applied to an interconnection module substrate for a semiconductor package according to an embodiment of the present invention;
FIGs. 12A to 12D are sectional views exemplarily illustrating a method of manufacturing an interconnection module substrate for a semiconductor package according to an embodiment of the present invention;
FIGs. 13A to 13D are sectional views exemplarily illustrating a method of manufacturing an interconnection module substrate for a semiconductor package according to another embodiment of the present invention;
FIGs. 14A and 14B are sectional views exemplarily illustrating a method of manufacturing a semiconductor package device with an interconnection module substrate for a semiconductor package according to an embodiment of the present invention; and
FIGs. 15A and 15B are sectional views for exemplarily illustrating a method of manufacturing a semiconductor package device with an interconnection module substrate for a semiconductor package according to another embodiment of the present invention.

### DETAILED DESCRIPTION OF THE PREFERRED EMBODIMENTS

Hereinafter, embodiments of the present invention will be described in detail with reference to the accompanying drawings. The sizes or thicknesses of the areas or parts shown in the accompanying drawings may be somewhat exaggerated for clarity and ease of description. Throughout the detailed description, the same reference symbols denote the same components.

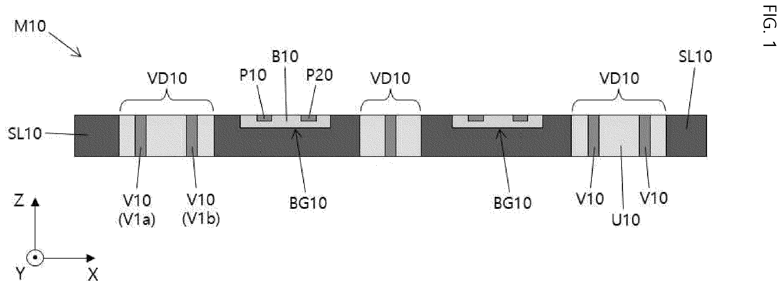

FIG. 1 is a sectional view schematically showing an interconnection module substrate M10 for a semiconductor package according to an embodiment of the present invention.

Referring to FIG. 1, the interconnection module substrate M10 according to the embodiment of the present invention may include a plurality of via-defining structures VD10, at least one interconnection bridge member BG10, and a substrate material layer SL10.

Each of the plurality of via-defining structures VD10 may include a substrate material unit U10 and a conductive via element V10 extending through the substrate material unit U10 in a vertical direction. The substrate material unit U10 may have, for example, a polygonal column shape or a block shape having a predetermined thickness, and the planar shape thereof as viewed from above may be variously changed. A via hole or a through hole (through space) similar thereto may be formed in the substrate material unit U10, and the conductive via element V10 may be formed in the via hole or the through hole (through space). The substrate material unit U10 may include an organic material or an inorganic material, and in some cases, may include a combination of organic and inorganic materials. The substrate material unit U10 may be made of an organic material, an inorganic material, or a combination of organic and inorganic materials. As a non-limiting example, the substrate material unit U10 may include an organic material used as a substrate material in the printed circuit board (PCB) field, or may include an inorganic material such as silicon. When the substrate material unit U10 includes silicon, the conductive via element V10 may be considered as a type of through silicon via (TSV). The substrate material unit U10 may include at least one of an insulator material and a semiconductor material.

The conductive via element V10 may be disposed so as to extend through the substrate material unit U10 in the vertical direction. The conductive via element V10 may extend from a lower surface to an upper surface of the substrate material unit U10. The conductive via element V10 may be exposed from the lower surface and the upper surface of the substrate material unit U10. The conductive via element V10 may also be referred to as a "via-type wire," a "via-containing wire," or a "via plug." The conductive via element V10 may include at least one of a metal or a metal compound. Any conductive material that can be applied to a typical via structure may be applied to the conductive via element V10. Although not shown in FIG. 1, a via land, i.e., a via extension portion, may be provided at each of both ends (lower end and upper end) of the conductive via element V10.

The plurality of via-defining structures VD10 may be disposed spaced apart from each other in a horizontal direction. At least some of the plurality of via-defining structures VD10 may have different configurations or may have different sizes. At least some of the plurality of via-defining structures VD10 may provide different inter-via pitch characteristics. In FIG. 1, three via-defining structures VD10 are shown for convenience, but in practice, a greater number of via-defining structures VD10 may be disposed. In view of a manufacturing process, the via-defining structure VD10 may be a preformed via-defining structure. In addition, the via-defining structure VD10 may have a three-dimensional (3D) structure. Thus, the via-defining structure VD10 may be a preformed 3D via-defining structure.

The at least one interconnection bridge member BG10 may be disposed spaced apart from or adjacent to the plurality of via-defining structures VD10 in the horizontal direction. As used herein, "adjacent" may include the concept of being in close proximity or contact as well as the concept of being adjacent in general. The interconnection bridge member BG10 may be disposed between at least two of the plurality of via-defining structures VD10. A plurality of interconnection bridge members BG10 may be used as needed.

The interconnection bridge member BG10 may serve to electrically connect a first semiconductor chip (that is, die) and a second semiconductor chip (that is, die) to each other. The interconnection bridge member BG10 may include a base portion B10 and a wiring structure formed on the base portion B10. The wiring structure may include a first connection pad portion P10 and a second connection pad portion P20. The first connection pad portion P10 may be electrically connected to the first semiconductor chip, and the second connection pad portion P20 may be electrically connected to the second semiconductor chip. The first connection pad portion P10 and the second connection pad portion P20 may be electrically connected to each other. A plurality of first connection pad portions P10 and a plurality of second connection pad portions P20 may be provided at one interconnection bridge member BG10.

The base portion B10 may include, e.g., a semiconductor substrate portion. The semiconductor substrate portion may include, e.g., silicon (Si), germanium (Ge), or silicon germanium (SiGe). In a specific example, the semiconductor substrate portion may include silicon (Si). However, the specific material of the semiconductor substrate portion is not limited thereto and may be variously changed. A given circuit portion may be formed on the base portion B10, and the circuit portion may include first and second connection pad portions P10 and P20. In view of the manufacturing process, the interconnection bridge member BG10 may be a preformed interconnection bridge.

The substrate material layer SL10 may be embedded in the space between and around the plurality of via-defining structures VD10 and the interconnection bridge member BG10 to form a single substrate shape together therewith. The substrate material layer SL10 may be a material layer for forming a substrate structure while physically binding the plurality of via-defining structures VD10 and the interconnection bridge members BG10 to each other. The substrate material layer SL10 may be formed, e.g., by molding.

The substrate material layer SL10 may be configured to expose the plurality of via-defining structures VD10 and the interconnection bridge member BG10. The lower surface and the upper surface of the via-defining structure VD10 may be exposed from the lower surface and the upper surface of the substrate material layer SL10, respectively. In addition, the upper surface of the interconnection bridge member BG10 may be exposed from the upper surface of the substrate material layer SL10. The via-defining structure VD10 may be disposed so as to extend through the substrate material layer SL10 in an upward-downward direction, i.e., in the vertical direction. The interconnection bridge member BG10 may be embedded and disposed in an upper surface part of the substrate material layer SL10. The first and second connection pad portions P10 and P20 may be exposed from the upper surface of the substrate material layer SL10.

The upper surface of the via-defining structure VD10, the upper surface of the interconnection bridge member BG10, and the upper surface of the substrate material layer SL10 may be disposed at the same level (height), or may be disposed at substantially the same level. The lower surface of the via-defining structure VD10 and the lower surface of the substrate material layer SL10 may be disposed at the same level (height), or may be disposed at substantially the same level. The via-defining structure VD10 may have the same or substantially the same thickness as the substrate material layer SL10. The interconnection bridge member BG10 may have a thickness less than the thickness of the substrate material layer SL10.

The substrate material layer SL10 may include, e.g., an organic material or may be made of an organic material. As a non-limiting example, the substrate material layer SL10 may be or include a molding compound. The substrate material layer SL10 may be an insulator. The substrate material layer SL10 may be a separate material layer from the substrate material unit U10. The substrate material layer SL10 and the substrate material unit U10 may have different material compositions. However, in some cases, the substrate material layer SL10 and the substrate material unit U10 may include the same material or may include similar materials.

In the embodiment of the present invention, the interconnection module substrate M10 for the semiconductor package may be manufactured by forming the substrate material layer SL10 after the plurality of via-defining structures VD10 and the at least one interconnection bridge member BG10 are manufactured and arranged according to need and purpose. According to the embodiment of the present invention, it is possible to realize an interconnection module substrate for a semiconductor package that is easy to variously design and easy to manufacture according to user need and purpose. In addition, it is possible to realize an interconnection module substrate for a semiconductor package which can be appropriately manufactured in response to various semiconductor package design plans, which can secure responsiveness to various electrode pitches, and which has excellent performance and durability.

In the embodiment shown in FIG. 1, the plurality of via-defining structures VD10 may include a first via-defining structure, and the first via-defining structure may correspond to, e.g., the via-defining structure VD10 on the far left side of FIG. 1. The first via-defining structure may include first and second conductive via elements V1a and V1b spaced apart from each other. The first and second conductive via elements V1a and V1b may have the same spacing at upper ends and lower ends thereof. In other words, the spacing between the upper ends of the first and second conductive via elements V1a and V1b may be the same or substantially the same as the spacing between the lower ends of the first and second conductive via elements V1a and V1b. In this case, the first via-defining structure may provide the same electrode pitch characteristics at the upper end and the lower end thereof. At this time, each of the first and second conductive via elements V1a and V1b may have a straight, vertically extending structure.

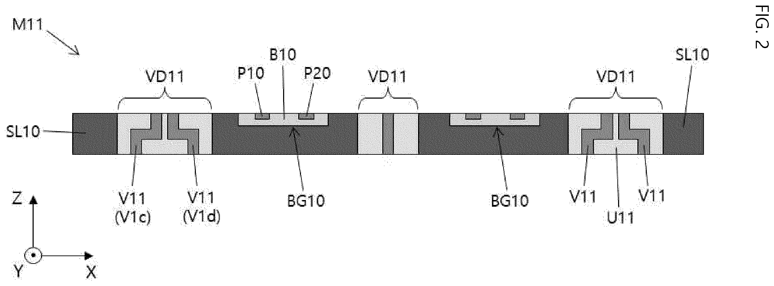

FIG. 2 is a sectional view schematically showing an interconnection module substrate M11 for a semiconductor package according to another embodiment of the present invention.

Referring to FIG. 2, the interconnection module substrate M11 according to this embodiment may include a plurality of via-defining structures VD11, at least one interconnection bridge member BG10, and a substrate material layer SL10. Each of the plurality of via-defining structures VD11 may include a substrate material unit U11 and a conductive via element V11 extending through the substrate material unit U11 in the vertical direction. The plurality of via-defining structures VD11 may be disposed spaced apart from each other in the horizontal direction. The at least one interconnection bridge member BG10 may be disposed spaced apart from or adjacent to the plurality of via-defining structures VD11 in the horizontal direction. The substrate material layer SL10 may be embedded in the space between and around the plurality of via-defining structures VD11 and the interconnection bridge member BG10 to form a single substrate shape together therewith, and may be formed so as to expose the plurality of via-defining structures VD11 and the interconnection bridge members BG10.

In this embodiment, the plurality of via-defining structures VD11 may include a first via-defining structure, and the first via-defining structure may correspond to, e.g., the via-defining structure VD11 on the far left side of FIG. 2. The first via-defining structure may include first and second conductive via elements V1c and V1d spaced apart from each other. The first and second conductive via elements V1c and V1d may have different spacings at upper ends and lower ends thereof. In other words, the spacing between the upper ends of the first and second conductive via elements V1c and V1d may be different from the spacing between the lower ends of the first and second conductive via elements V1c and V1d. In this case, the first via-defining structure may provide different electrode pitch characteristics at the upper end and the lower end thereof. At this time, at least one of the first and second conductive via elements V1c and V1d may have a bent structure. Each of the first and second conductive via elements V1c and V1d may have a bent structure.

For example, the first and second conductive via elements V1c and V1d may have a first spacing at the upper ends thereof, and may have a second spacing greater than the first spacing at the lower ends thereof. Consequently, the electrode pitch may be extended at a lower part of the first via-defining structure by the first and second conductive via elements V1c and V1d. The first conductive via element V1c may have a structure that is bent at least twice from a lower part to an upper part thereof. The first conductive via element V1c may be bent so as to be closer to the second conductive via element V1d in an upward direction. In this case, the first conductive via element V1c may include one or more vertical components and one or more horizontal components. The vertical components may be referred to as via plug components, and the horizontal components may be referred to as patterned layer components. In addition, the substrate material unit U11 may have a multilayer structure, such as a double layer or more, as needed. Meanwhile, the second conductive via element V1d may have a symmetrical structure with the first conductive via element V1c, or may have a structure similar thereto. However, the detailed structure of each of the first and second conductive via elements V1c and V1d described with reference to FIG. 2 is exemplary and may be variously changed in some cases.

Since the configurations and features of the interconnection bridge member BG10 and the substrate material layer SL10 in FIG. 2 may be the same as those described with reference to FIG. 1, a repeated description thereof will be omitted.

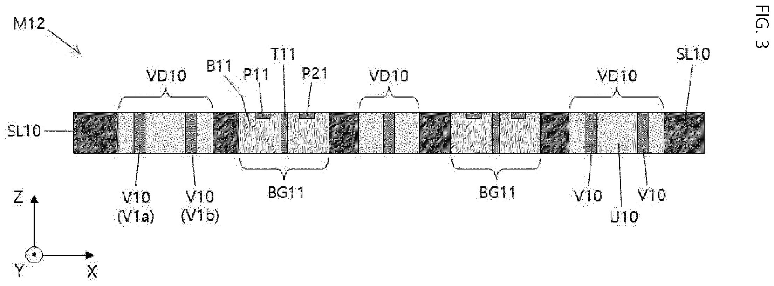

FIG. 3 is a sectional view schematically showing an interconnection module substrate M12 for a semiconductor package according to another embodiment of the present invention.

Referring to FIG. 3, the interconnection module substrate M12 according to this embodiment may include a plurality of via-defining structures VD10, at least one interconnection bridge member BG11, and a substrate material layer SL10. Each of the plurality of via-defining structures VD10 may include a substrate material unit U10 and a conductive via element V10 extending through the substrate material unit U10 in the vertical direction. The plurality of via-defining structures VD10 may be disposed spaced apart from each other in the horizontal direction. The at least one interconnection bridge member BG11 may be disposed spaced apart from or adjacent to the plurality of via-defining structures VD10 in the horizontal direction. The substrate material layer SL10 may be embedded in the space between and around the plurality of via-defining structures VD10 and the interconnection bridge member BG11 to form a single substrate shape together therewith, and may be formed so as to expose the plurality of via-defining structures VD10 and the interconnection bridge members BG11.

In this embodiment, the interconnection bridge member BG11 may have the same thickness or substantially the same thickness as the substrate material layer SL10. The interconnection bridge member BG11 may have the same thickness or substantially the same thickness as the via-defining structure VD10. The interconnection bridge member BG11 may be disposed so as to extend through the substrate material layer SL10 in the upward-downward direction, i.e., in the vertical direction. The interconnection bridge member BG11 may further include a through electrode T11. The through electrode T11 may be formed so as to extend through the interconnection bridge member BG11 in the upward-downward direction, i.e., in the vertical direction. The through electrode T11 may be a through silicon via (TSV) or an electrode equivalent thereto. The position of the through electrode T11 shown in FIG. 3 is exemplary only, and the position thereof may be changed. One interconnection bridge member BG11 may be provided with one or more through electrodes T11. The through electrode T11 may provide electrical connectivity between at least one semiconductor chip and an external circuit. The routing density may be improved by the through electrode T11.

In FIG. 3, reference symbol B11 denotes a base portion of the interconnection bridge member BG11, P11 denotes a first connection pad portion, and P21 denotes a second connection pad portion. The base portion B11 may have the same thickness or substantially the same thickness as the substrate material layer SL10. The through electrode T11 may be formed so as to extend through the base portion B11.

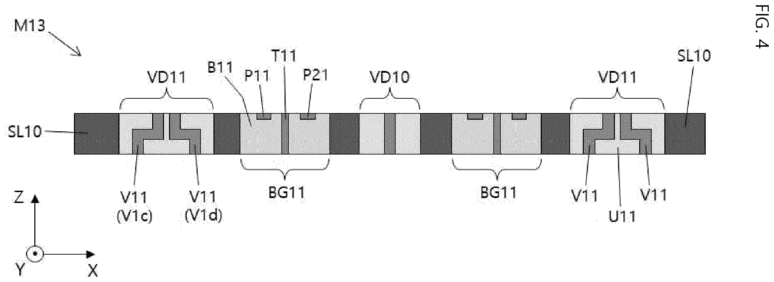

FIG. 4 is a sectional view schematically showing an interconnection module substrate M13 for a semiconductor package according to a further embodiment of the present invention.

Referring to FIG. 4, the interconnection module substrate M13 according to this embodiment may include a plurality of via-defining structures VD11, at least one interconnection bridge member BG11, and a substrate material layer SL10. The via-defining structure VD11 may be the same as that described with reference to FIG. 2, and the interconnection bridge member BG11 may be the same as that described with reference to FIG. 3.

In some cases, the features of at least two of the embodiments of FIGs. 1 to 4 may be incorporated into one interconnection module substrate.

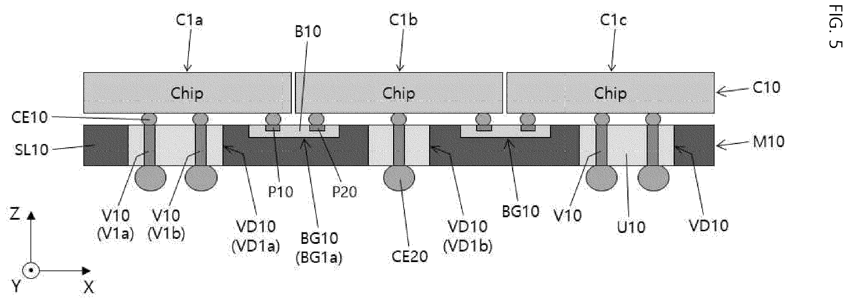

FIG. 5 is a sectional view schematically showing a semiconductor package device including an interconnection module substrate M10 for a semiconductor package according to an embodiment of the present invention.

Referring to FIG. 5, the semiconductor package device according to the embodiment of the present invention may include an interconnection module substrate M10 and a plurality of semiconductor chips (that is, dies) C10 mounted on an upper surface of the interconnection module substrate M10 so as to be spaced apart from or adjacent to each other in the horizontal direction. Exemplarily, three semiconductor chips C10, which may be referred to as first, second, and third semiconductor chips C1a, C1b, and C1c, are shown. The interconnection module substrate M10 may have, for example, a configuration as described with reference to FIG. 1. The interconnection module substrate M10 may include a plurality of via-defining structures VD10, at least one interconnection bridge member BG10, and a substrate material layer SL10.

The plurality of semiconductor chips C10 may include first and second semiconductor chips C1a and C1b, and the plurality of via-defining structures VD10 may include first and second via-defining structures VD1a and VD1b. The at least one interconnection bridge member BG10 may include a first interconnection bridge member BG1a disposed between the first and second via-defining structures VD1a and VD1b. The first semiconductor chip C1a may be connected to a conductive via element V10 of the first via-defining structure VD1a and a first connection pad portion P10 of the first interconnection bridge member BG1a. The second semiconductor chip C1b may be connected to a conductive via element V10 of the second via-defining structure VD1b and a second connection pad portion P20 of the first interconnection bridge member BG1a.

The semiconductor package device may further include a first electrical connection element CE10 disposed between the interconnection module substrate M10 and the semiconductor chip C10. In addition, the semiconductor package device may further include a second electrical connection element CE20 disposed on a lower surface of the interconnection module substrate M10 so as to be connected to the conductive via element V10. A plurality of first electrical connection elements CE10 may be provided, and a plurality of second electrical connection elements CE20 may be provided. As a non-limiting example, the first electrical connection element CE10 may be a bump or microbump. As a non-limiting example, the second electrical connection element CE20 may be a solder ball. However, the specific types of the first and second electrical connection elements CE10 and CE20 are not limited thereto, and may be changed. In addition, a predetermined redistribution layer (RDL) may be formed on an upper surface of the interconnection module substrate M10.

At least two of the plurality of semiconductor chips C10 may be different types of chips. In other words, the plurality of semiconductor chips C10 may include heterogeneous chips. For example, the plurality of semiconductor chips C10 may include a memory chip and a logic chip, and may further include other types of chips. In some cases, one or more semiconductor chips (that is, dies) may be further stacked (mounted) on at least one of the plurality of semiconductor chips C10. The interconnection module substrate according to the embodiment of the present invention may be used for a 2.5D package or a 3D package.

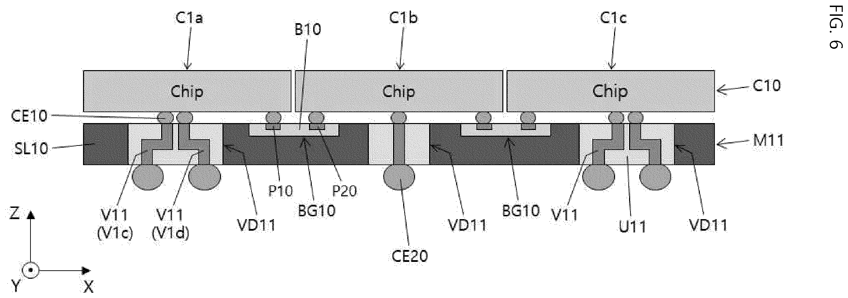

FIG. 6 is a sectional view schematically showing a semiconductor package device including an interconnection module substrate M11 for a semiconductor package according to another embodiment of the present invention.

Referring to FIG. 6, the semiconductor package device according to this embodiment may include an interconnection module substrate M11 and a plurality of semiconductor chips C10 mounted on an upper surface of the interconnection module substrate M11 so as to be spaced apart from or adjacent to each other in the horizontal direction. Exemplarily, three semiconductor chips C10, which may be referred to as first, second, and third semiconductor chips C1a, C1b, and C1c, are shown. The interconnection module substrate M11 may have, for example, a configuration as described with reference to FIG. 2. The interconnection module substrate M11 may include a plurality of via-defining structures VD11, at least one interconnection bridge member BG10, and a substrate material layer SL10.

In this embodiment, the plurality of via-defining structures VD11 may include a first via-defining structure, and the first via-defining structure may correspond to, e.g., the via-defining structure VD11 on the far left side of FIG. 6. The first via-defining structure may include first and second conductive via elements V1c and V1d spaced apart from each other. The first and second conductive via elements V1c and V1d may have different spacings at upper ends and lower ends thereof. In this case, the first via-defining structure may provide different electrode pitch characteristics at the upper end and the lower end thereof. For example, the first and second conductive via elements V1c and V1d may have a first spacing at the upper ends thereof, and may have a second spacing greater than the first spacing at the lower ends thereof. Consequently, the pitch between second electrical connection elements CE20 may remain the same as or similar to FIG. 5. A predetermined redistribution layer (RDL) may be formed on an upper surface of the interconnection module substrate M11.

Similarly to what is shown in and described with reference to FIGs. 5 and 6, it is possible to manufacture a semiconductor package device to which the interconnection module substrates M12 and M13 according to the embodiments of FIGs. 3 and 4 are applied.

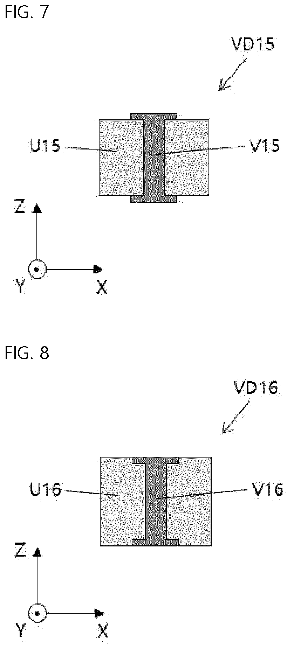

FIGs. 7 to 10 are sectional views exemplarily showing via-defining structures VD15 to VD18 that can be applied to an interconnection module substrate for a semiconductor package according to an embodiment of the present invention.

Referring to FIG. 7, the via-defining structure VD15 may include a substrate material unit U15 and a conductive via element V15 extending through the substrate material unit U15 in the vertical direction. A via land, i.e., a via extension portion (via pad portion), may be provided at each of both ends of the conductive via element V15. The via land may protrude somewhat from the substrate material unit U15.

Referring to FIG. 8, the via-defining structure VD16 may include a substrate material unit U16 and a conductive via element V16 extending through the substrate material unit U16 in the vertical direction. A via land, i.e., a via extension portion (via pad portion), may be provided at each of both ends of the conductive via element V16. The via land may not protrude from the substrate material unit U16. In this case, the substrate material unit U16 and the conductive via element V16 may have the same thickness, or may have substantially the same thickness.

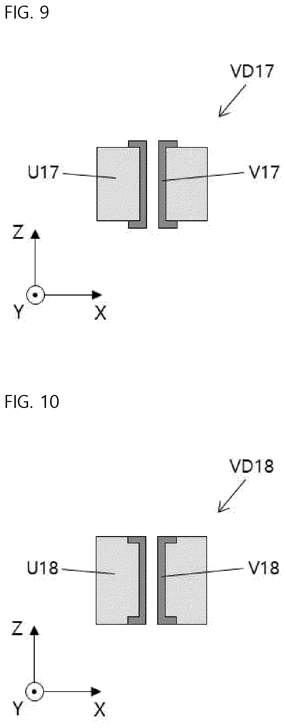

Referring to FIG. 9, the via-defining structure VD17 may include a substrate material unit U17 and a conductive via element V17 extending through the substrate material unit U17 in the vertical direction. The conductive via element V17 may have a column shape or a pipe shape having a hollow portion, and a via land, i.e., a via expansion portion (via pad portion), may be provided at each of both ends of the conductive via element. The via land may protrude somewhat from the substrate material unit U17. The hollow portion of the via-defining structure VD17 may be filled with a predetermined material.

Referring to FIG. 10, the via-defining structure VD18 may include a substrate material unit U18 and a conductive via element V18 extending through the substrate material unit U18 in the vertical direction. The conductive via element V18 may have a column shape or a pipe shape having a hollow portion, and a via land, i.e., a via expansion portion (via pad portion), may be provided at each of both ends of the conductive via element. The via land may not protrude from the substrate material unit U18. In this case, the thicknesses of the substrate material unit U18 and the conductive via element V18 in a z-axis direction may be the same or substantially the same. The hollow portion of the conductive via element V18 may be filled with a predetermined material.

The configurations of the via-defining structures VD15 to VD18 described with reference to FIGs. 7 to 10, or variations thereof, may be applied to the embodiments of FIGs. 1 to 6. The conductive via elements V15 to V18 of the via-defining structures VD15 to V18 may be modified so as to have a bent structure. In the embodiments of the present invention, the conductive via element may be formed by filling or plating, and the detailed structure/shape thereof may be variously changed.

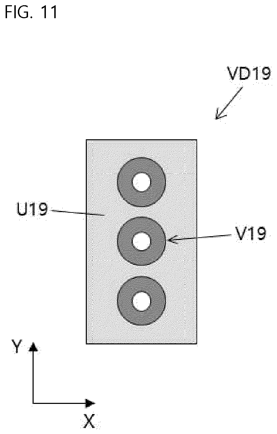

FIG. 11 is a plan view exemplarily showing a via-defining structure VD19 that can be applied to an interconnection module substrate for a semiconductor package according to an embodiment of the present invention.

Referring to FIG. 11, the via-defining structure VD19 may include a substrate material unit U19 and a conductive via element V19 extending through the substrate material unit U19 in the vertical direction. A plurality of conductive via elements V19 may be arranged in a predetermined manner. The plurality of conductive via elements V19 may be arranged to form a single row, a plurality of rows, or a plurality of staggered rows. The arrangement of the plurality of conductive via elements V19 may be variously changed, as needed. In addition, the number of conductive via elements V19 included in one via-defining structure VD19, the size of the via-defining structure VD19, and the overall shape of the via-defining structure VD19 may be variously changed.

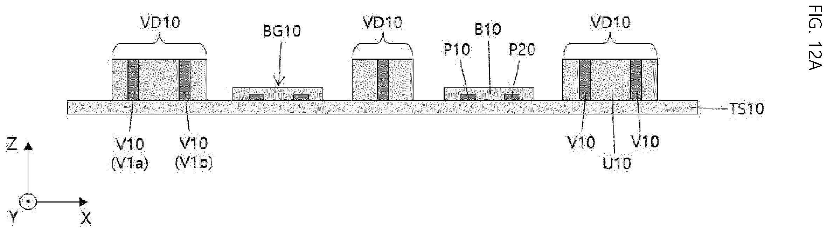

FIGs. 12A to 12D are sectional views exemplarily illustrating a method of manufacturing an interconnection module substrate for a semiconductor package according to an embodiment of the present invention.

Referring to FIG. 12A, a plurality of preformed via-defining structures VD10 and at least one interconnection bridge member BG10 may be disposed on a temporary substrate TS10 so as to be spaced apart from or adjacent to each other in the horizontal direction. The plurality of preformed via-defining structures VD10 and the at least one interconnection bridge member BG10 may be attached to an upper surface of the temporary substrate TS10 in an upside-down position. The plurality of preformed via-defining structures VD10 may be approximately two-dimensionally arranged in a plane.

The plurality of preformed via-defining structures VD10 may serve to provide electrical connectivity in the vertical direction. Each of the plurality of preformed via-defining structures VD10 may include a substrate material unit U10 and a conductive via element V10 extending through the substrate material unit U10 in the vertical direction. As a non-limiting example, the plurality of preformed via-defining structures VD10 may be easily manufactured using a printed circuit board (PCB) manufacturing process. A plurality of conductive via elements VD10 may be formed at a single board substrate, and the board substrate with the plurality of conductive via elements VD10 may be appropriately cut within a given design to manufacture the plurality of preformed via-defining structures VD10.

The interconnection bridge member BG10 may serve to electrically connect a first semiconductor chip (that is, die) and a second semiconductor chip (that is, die) to each other. The interconnection bridge member BG10 may include a base portion B10 and a wiring structure formed on the base portion B10. The wiring structure may include a first connection pad portion P10 and a second connection pad portion P20. The first connection pad portion P10 may be electrically connected to the first semiconductor chip, and the second connection pad portion P20 may be electrically connected to the second semiconductor chip. The first connection pad portion P10 and the second connection pad portion P20 may be electrically connected to each other. A plurality of first connection pad portions P10 and a plurality of second connection pad portions P20 may be provided at one interconnection bridge member BG10. The base portion B10 may include, e.g., a semiconductor substrate portion. The semiconductor substrate portion may include, e.g., silicon (Si), germanium (Ge), or silicon germanium (SiGe). In a specific example, the semiconductor substrate portion may include silicon (Si). However, the specific material of the semiconductor substrate portion is not limited thereto and may be variously changed. A circuit portion may be formed on the base portion B10, and the circuit portion may include first and second connection pad portions P10 and P20.

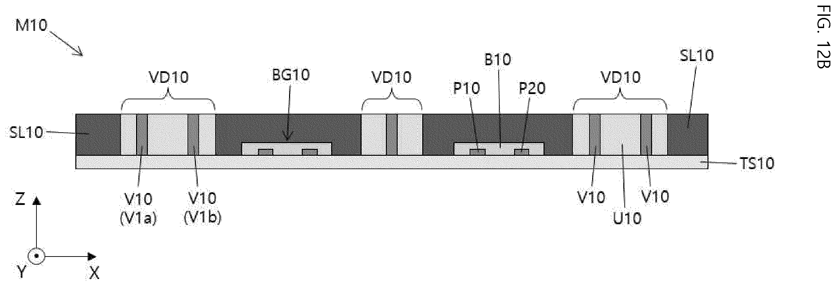

Referring to FIG. 12B, a substrate material layer SL10 embedded in the space between and around the plurality of preformed via-defining structures VD10 and the interconnection bridge member BG10 to form a single substrate shape together therewith may be formed on the temporary substrate TS10. The substrate material layer SL10 may be a material layer for forming a substrate structure while physically binding the plurality of via-defining structures VD10 and the interconnection bridge members BG10 to each other. The substrate material layer SL10 may be formed, e.g., by molding. As a non-limiting example, a manufacturing process, including formation of the substrate material layer SL10, may be easily performed using a fan-out process, which is a type of semiconductor package process. The plurality of preformed via-defining structures VD10, the interconnection bridge members BG10, and the substrate material layer SL10 may constitute an interconnection module substrate M10.

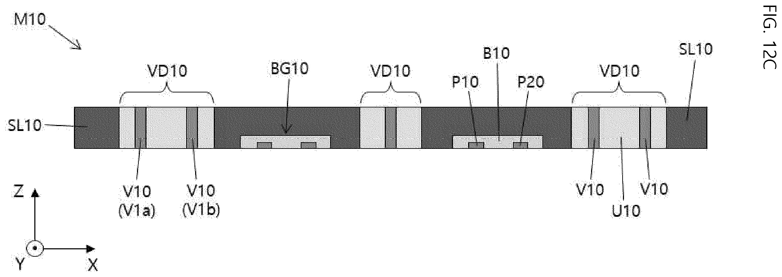

Referring to FIG. 12C, the temporary substrate TS10 (FIG. 12B) may be removed from the interconnection module substrate M10. The temporary substrate TS10 (FIG. 12B) may be separated and removed from the interconnection module substrate M10.

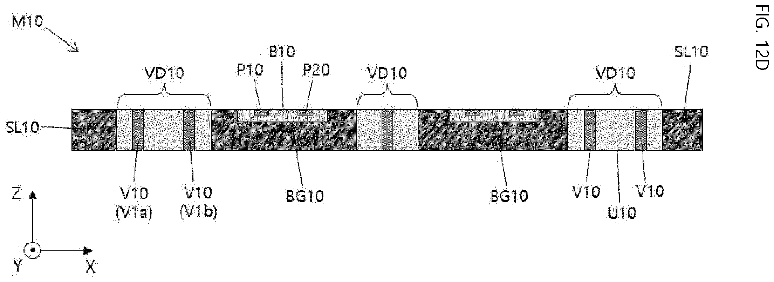

Referring to FIG. 12D, the resulting product of FIG. 12C may be disposed upside down. A step of grinding at least one of an upper surface and a lower surface of the interconnection module substrate M10 may be further performed as needed. Residues or foreign substances on the upper surface or the lower surface of the interconnection module substrate M10 may be removed, and conductor (for example, metal or metal compound) parts may be exposed, by grinding. In addition, flatness of the upper surface or the lower surface of the interconnection module substrate M10 may be improved by grinding. If a temporary protective material is applied to the upper surface or the lower surface of the interconnection module substrate M10, the temporary protective material may be removed. Furthermore, a redistribution layer (RDL) may be further formed on the upper surface of the interconnection module substrate M10 as needed.

The resulting product of FIG. 12D may correspond to the interconnection module substrate M10 described with reference to FIG. 1. Consequently, the entirety of the description given with reference to FIG. 1 may be applied to the interconnection module substrate M10 of FIG. 12D. In the interconnection module substrate M10 of FIG. 12D, first and second conductive via elements V1a and V1b may have the same spacing at upper ends and lower ends thereof.

In the embodiment of the present invention, the interconnection module substrate M10 for the semiconductor package may be manufactured by forming the substrate material layer SL10 after the plurality of via-defining structures VD10 and the at least one interconnection bridge member BG10 are manufactured and arranged according to need and purpose. According to the embodiment of the present invention, it is possible to realize an interconnection module substrate for a semiconductor package that is easy to variously design and easy to manufacture according to user need and purpose. In addition, it is possible to realize an interconnection module substrate for a semiconductor package which can be appropriately manufactured in response to various semiconductor package design plans, which can secure responsiveness to various electrode pitches, and which has excellent performance and durability.

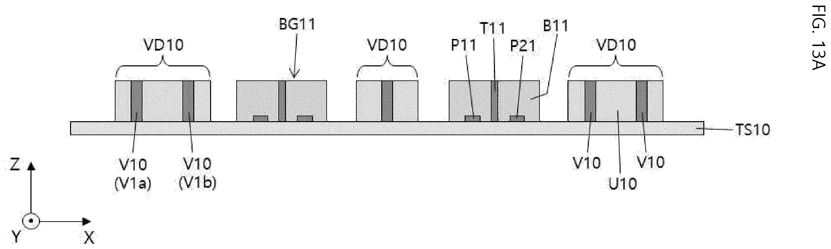

FIGs. 13A to 13D are sectional views exemplarily illustrating a method of manufacturing an interconnection module substrate for a semiconductor package according to another embodiment of the present invention. This embodiment exemplarily shows a method of manufacturing the interconnection module substrate M12 of FIG. 3.

Referring to FIG. 13A, a plurality of preformed via-defining structures VD10 and at least one interconnection bridge member BG11 may be disposed on a temporary substrate TS10 so as to be spaced apart from or adjacent to each other in the horizontal direction. The plurality of preformed via-defining structures VD10 and the at least one interconnection bridge member BG11 may be attached to an upper surface of the temporary substrate TS10 in an upside-down position.

The interconnection bridge member BG11 may have the same thickness or substantially the same thickness as the via-defining structure VD10. The interconnection bridge member BG11 may include a base portion B11 and a wiring structure formed on the base portion B11. The wiring structure may include a first connection pad portion P11 and a second connection pad portion P21. The interconnection bridge member BG11 may further include a through electrode T11. The through electrode T11 may be formed so as to extend through the interconnection bridge member BG11 in the upward-downward direction, i.e., in the vertical direction. The through electrode T11 may be a through silicon via (TSV) or an electrode equivalent thereto. The position of the through electrode T11 shown in FIG. 13A is exemplary only, and the position thereof may be changed. One interconnection bridge member BG11 may be provided with one or more through electrodes T11. The through electrode T11 may provide electrical connectivity between at least one semiconductor chip and an external circuit. The through electrode T11 may be formed so as to extend through the base portion B11.

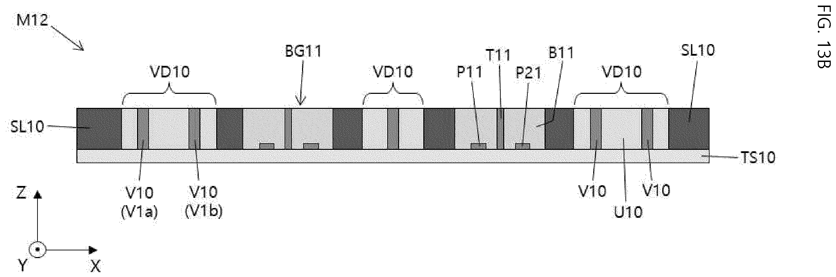

Referring to FIG. 13B, a substrate material layer SL10 embedded in the space between and around the plurality of preformed via-defining structures VD10 and the interconnection bridge member BG11 to form a single substrate shape together therewith may be formed on the temporary substrate TS10. The substrate material layer SL10 may be a material layer for forming a substrate structure while physically binding the plurality of via-defining structures VD10 and the interconnection bridge members BG11 to each other. The substrate material layer SL10 may be formed, e.g., by molding. The plurality of preformed via-defining structures VD10, the interconnection bridge members BG11, and the substrate material layer SL10 may constitute an interconnection module substrate M12.

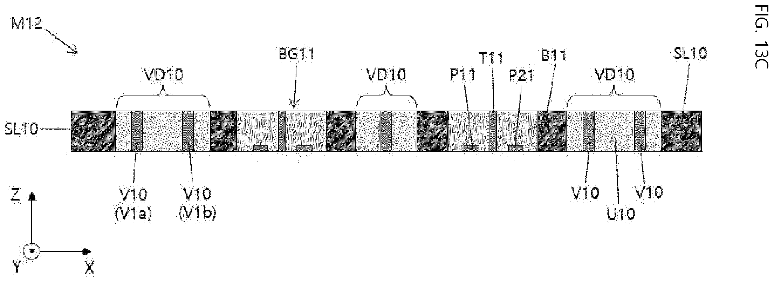

Referring to FIG. 13C, the temporary substrate TS10 (FIG. 13B) may be removed from the interconnection module substrate M12. The temporary substrate TS10 (FIG. 13B) may be separated and removed from the interconnection module substrate M12.

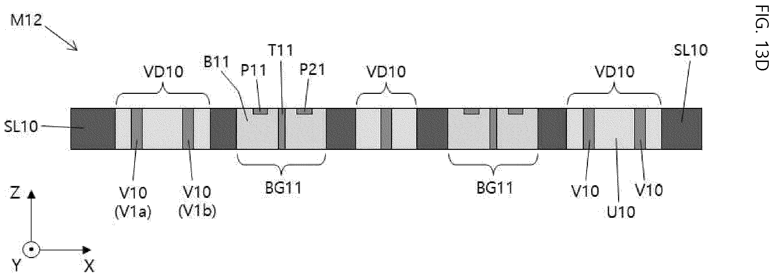

Referring to FIG. 13D, the resulting product of FIG. 13C may be disposed upside down. A step of grinding at least one of an upper surface and a lower surface of the interconnection module substrate M12 may be further performed as needed. In addition, a redistribution layer (RDL) may be further formed on the upper surface of the interconnection module substrate M12 as needed.

The resulting product of FIG. 13D may correspond to the interconnection module substrate M12 described with reference to FIG. 3. Consequently, the entirety of the description made with reference to FIG. 3 may be applied to the interconnection module substrate M12 of FIG. 13D. When the interconnection bridge member BG11 of the interconnection module substrate M12 further includes the through electrode T11, the effect of improving the routing density may be obtained by the through electrode T11.

Although not shown, the interconnection module substrates M11 and M13 of FIGs. 2 and 4 may also be easily manufactured using methods similar to the manufacturing methods of FIGs. 12A to 12D and FIGs. 13A to 13D. This may be easily understood from the foregoing description. When first and second conductive via elements V1c and V1d have different spacings at upper ends and lower ends thereof, as in the interconnection module substrates M11 and M13 of FIGs. 2 and 4, the via-defining structure including the same may provide different electrode pitch characteristics at the upper end and the lower end thereof. The first and second conductive via elements V1c and V1d may have a first spacing at the upper ends thereof, and may have a second spacing greater than the first spacing at the lower ends thereof.

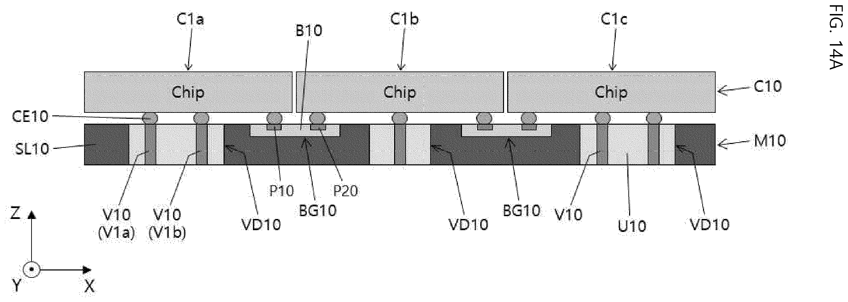

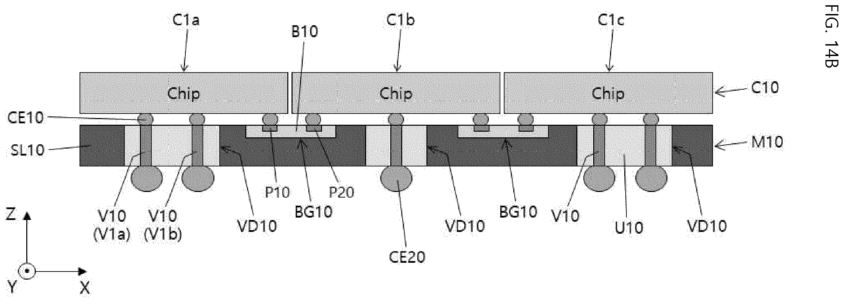

FIGs. 14A and 14B are sectional views exemplarily illustrating a method of manufacturing a semiconductor package device with an interconnection module substrate for a semiconductor package according to an embodiment of the present invention.

Referring to FIG. 14A, an interconnection module substrate M10 may be prepared. The interconnection module substrate M10 may have, for example, a configuration as described with reference to FIG. 1. The interconnection module substrate M10 may include a plurality of via-defining structures VD10, at least one interconnection bridge member BG10, and a substrate material layer SL10.

Subsequently, a plurality of semiconductor chips C10 may be mounted on an upper surface of the interconnection module substrate M10 so as to be spaced apart from or adjacent to each other in the horizontal direction. Exemplarily, three semiconductor chips C10, which may be referred to as first, second, and third semiconductor chips C1a, C1b, and C1c, are shown.

A first electrical connection element CE10 may be disposed between the interconnection module substrate M10 and the semiconductor chip C10. A plurality of first electrical connection elements CE10 may be provided. As a non-limiting example, the first electrical connection element CE10 may be a bump or microbump. However, the specific type of the first electrical connection element CE10 is not limited thereto, and may be changed. A predetermined redistribution layer (RDL) may be formed on an upper surface of the interconnection module substrate M10.

Referring to FIG. 14B, a second electrical connection element CE20 connected to a conductive via element V10 may be formed on a lower surface of the interconnection module substrate M10. A plurality of second electrical connection elements CE20 may be provided so as to correspond to at least a plurality of conductive via elements V10. As a non-limiting example, the second electrical connection element CE20 may be a solder ball. The solder ball may be attached to the lower surface of the interconnection module substrate M10 through a predetermined attachment process. However, the specific type of the second electrical connection element CE20 is not limited thereto, and may be changed.

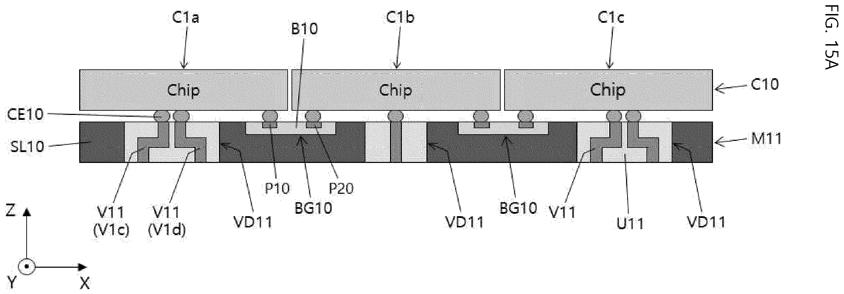

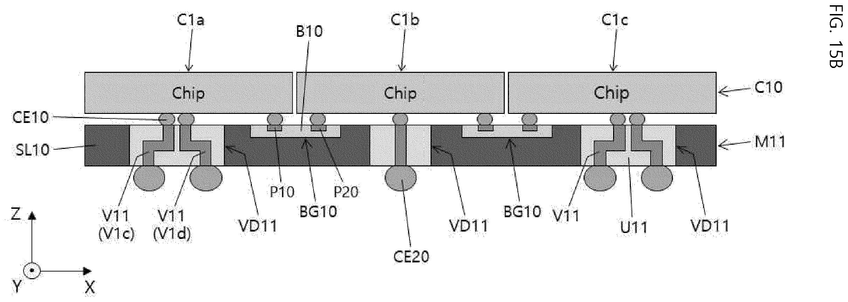

FIGs. 15A and 15B are sectional views for exemplarily illustrating a method of manufacturing a semiconductor package device with an interconnection module substrate for a semiconductor package according to another embodiment of the present invention.

Referring to FIG. 15A, an interconnection module substrate M11 may be prepared. The interconnection module substrate M11 may have, for example, a configuration as described with reference to FIG. 2. The interconnection module substrate M11 may include a plurality of via-defining structures VD11, at least one interconnection bridge member BG10, and a substrate material layer SL10. Subsequently, a plurality of semiconductor chips C10 may be mounted on an upper surface of the interconnection module substrate M11 so as to be spaced apart from or adjacent to each other in the horizontal direction. A first electrical connection element CE10 may be disposed between the interconnection module substrate M11 and the semiconductor chip C10.

Referring to FIG. 15B, a second electrical connection element CE20 connected to a conductive via element V11 may be formed on a lower surface of the interconnection module substrate M11. A plurality of second electrical connection elements CE20 may be provided so as to correspond to at least a plurality of conductive via elements V11.

Although not shown, it is possible to manufacture a semiconductor package device to which the interconnection module substrates M12 and M13 according to the embodiments of FIGs. 3 and 4 are applied, similarly to what was described in the embodiment of FIGs. 14A and 14B and the embodiment of FIGs. 15A and 15B.

As is apparent from the above description, according to embodiments of the present invention described above, it is possible to realize an interconnection module substrate for a semiconductor package that is easy to variously design and easy to manufacture according to user need and purpose. In addition, according to the embodiments of the present invention, it is possible to realize an interconnection module substrate for a semiconductor package which can be appropriately manufactured in response to various semiconductor package design plans, which can secure responsiveness to various electrode pitches, and which has excellent performance and durability. In particular, according to an embodiment of the present invention, various designs may be easily implemented by forming an interconnection module substrate using a preformed three-dimensional via-defining structure and an interconnection bridge member, for example, by molding.

When the interconnection module substrate according to the embodiment of the present invention is used, it is possible to easily manufacture a semiconductor package device having excellent performance.

However, the effects of the present invention are not limited to the above effects, and may be variously expanded without departing from the technical ideas and scope of the present invention.

Preferred embodiments of the present invention have been disclosed herein, and although certain terms are used, they are used in a general sense to facilitate the description and understanding of the invention, and are not intended to limit the scope of the invention. In addition to the embodiments disclosed herein, other modifications based on the technical ideas of the present invention will be apparent to those skilled in the art to which the present invention pertains. It will be apparent to those skilled in the art that the interconnection module substrate for the semiconductor package according to each of the embodiments described with reference to FIGs. 1 to 15B, the semiconductor package device including the same, and the manufacturing methods thereof may be subject to various substitutions, changes, and modifications without departing from the technical ideas of the present invention. The scope of the invention is therefore not to be defined by the embodiments described above but by the technical ideas recited in the appended claims.

## Claims

1. An interconnection module substrate for a semiconductor package, the interconnection module substrate comprising:
a plurality of via-defining structures disposed spaced apart from each other in a horizontal direction, each of the plurality of via-defining structures comprising a substrate material unit and a conductive via element extending through the substrate material unit in a vertical direction;
at least one interconnection bridge member disposed spaced apart from or adjacent to the plurality of via-defining structures in the horizontal direction; and
a substrate material layer embedded in a space between and around the plurality of via-defining structures and the interconnection bridge member to form a single substrate shape together therewith, the substrate material layer being configured to expose the plurality of via-defining structures and the interconnection bridge member.

2. The interconnection module substrate according to claim 1, wherein
the plurality of via-defining structures comprises a first via-defining structure,
the first via-defining structure comprises first and second conductive via elements spaced apart from each other, and
the first and second conductive via elements have the same spacing at upper ends and lower ends thereof.

3. The interconnection module substrate according to claim 1, wherein
the plurality of via-defining structures comprises a first via-defining structure,
the first via-defining structure comprises first and second conductive via elements spaced apart from each other, and
the first and second conductive via elements have a first spacing at upper ends thereof and have a second spacing greater than the first spacing at lower ends thereof.

4. The interconnection module substrate according to claim 3, wherein at least one of the first and second conductive via elements has a bent structure.

5. The interconnection module substrate according to claim 1, wherein the interconnection bridge member comprises a first connection pad portion electrically connected to a first semiconductor chip and a second connection pad portion electrically connected to a second semiconductor chip.

6. The interconnection module substrate according to claim 1, wherein the interconnection bridge member comprises a base portion and a wiring structure formed on the base portion.

7. The interconnection module substrate according to claim 1, wherein the interconnection bridge member has a thickness less than a thickness of the substrate material layer.

8. The interconnection module substrate according to claim 1, wherein
the interconnection bridge member has the same thickness or substantially the same thickness as the substrate material layer, and
the interconnection bridge member comprises a through silicon via (TSV) or a through electrode equivalent thereto.

9. A semiconductor package device comprising:
the interconnection module substrate according to claim 1; and
a plurality of semiconductor chips mounted on an upper surface of the interconnection module substrate so as to be spaced apart from or adjacent to each other in a horizontal direction.

10. The interconnection module substrate according to claim 9, wherein
the plurality of semiconductor chips comprises first and second semiconductor chips,
the plurality of via-defining structures comprises first and second via-defining structures,
the at least one interconnection bridge member comprises a first interconnection bridge member disposed between the first and second via-defining structures,
the first semiconductor chip is connected to a conductive via element of the first via-defining structure and a first connection pad portion of the first interconnection bridge member, and
the second semiconductor chip is connected to a conductive via element of the second via-defining structure and a second connection pad portion of the first interconnection bridge member.

11. The interconnection module substrate according to claim 9, wherein
a first electrical connection element is disposed between the interconnection module substrate and the semiconductor chip, and
a second electrical connection element connected to the conductive via element is disposed on a lower surface of the interconnection module substrate.

12. A method of manufacturing an interconnection module substrate for a semiconductor package, the method comprising:
disposing a plurality of preformed via-defining structures, each comprising a substrate material unit and a conductive via element extending through the substrate material unit in a vertical direction, and at least one interconnection bridge member on a temporary substrate so as to be spaced apart from or adjacent to each other in a horizontal direction;
forming a substrate material layer embedded in a space between and around the plurality of via-defining structures and the interconnection bridge member to form a single substrate shape together therewith on the temporary substrate; and
removing the temporary substrate from an interconnection module substrate comprising the plurality of preformed via-defining structures, the interconnection bridge member, and the substrate material layer.

13. The method according to claim 12, further comprising grinding at least one of an upper surface and a lower surface of the interconnection module substrate.

14. A method of manufacturing a semiconductor package device, the method comprising:
preparing an interconnection module substrate using the method according to claim 12; and
mounting a plurality of semiconductor chips on an upper surface of the interconnection module substrate so as to be spaced apart from or adjacent to each other in a horizontal direction.

15. The method according to claim 14, further comprising forming an electrical connection element connected to the conductive via element on a lower surface of the interconnection module substrate.
